# EUROPEAN PATENT SPECIFICATION

(11) **EP 0 987 739 B1**
(45) Date of publication and mention of the grant of the patent: **01.03.2006**
(21) Application number: 99306965.7
(22) Date of filing: 02.09.1999
(51) Int. Cl.: H01L 21/00, H01L 21/304, H01L 21/78

(54) **Arrangement configured to support substrate during a dicing process**
Anordnung zum Tragen eines Substrates während eines angepassten Schneidverfahrens
Arrangement configuré pour supporter un substrat pendant un procédé de découpage

(30) Priority: 18.09.1998 US 156593; 08.04.1999 US 288252
(43) Date of publication of application: 22.03.2000
(73) Proprietor: Towa Corporation, Kyoto (JP)
(72) Inventor: Tieber, Alois, San Jose, Califonia 95120 (US)
(74) Representative: Morton, Colin David

(56) References cited:
- DE-A- 19 628 237
- US-A- 3 976 288
- US-A- 4 296 542
- US-A- 4 600 936
- US-A- 5 803 797

## Description

### BACKGROUND OF THE INVENTION

### Field of the Invention

The present invention relates to an arrangement configured to support a substrate during a dicing process for cutting the substrate with no tape for adhesion using a nest.

### Description of the Background Art

During the fabrication of integrated circuit chips, multiple integrated circuit chips are often arranged on a single substrate, e.g., wafer or circuit board, which is eventually diced to separate the integrated circuit chips. Although a substrate may be sawed, or diced, to create individual chips at substantially any point during an overall fabrication process, the substrate is typically sawed after ball grid arrays and dies are formed on the substrate.

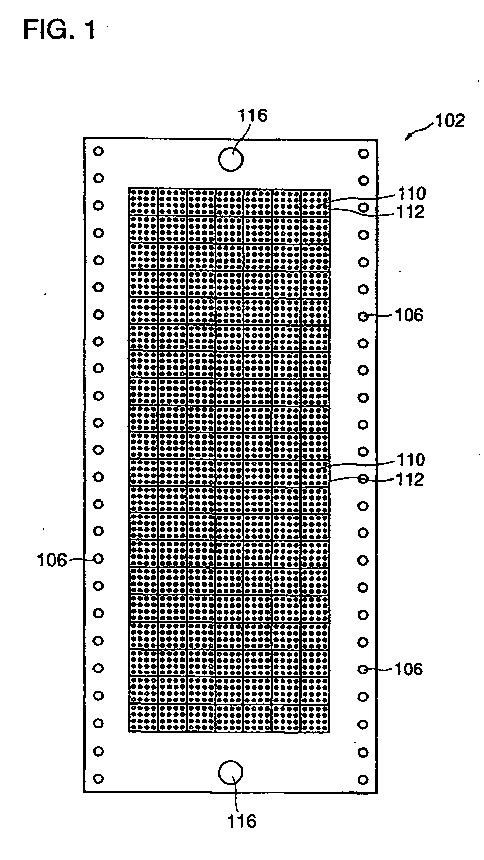

Fig. 1 is a diagrammatic representation of a contact, or ball grid array (BGA) side of a conventional substrate. A substrate 102 includes individual integrated circuit chips 112, each of which includes a ball grid array 110 of contacts, as will be appreciated by those skilled in the art. In general, the number of integrated circuit chips 112 formed on substrate 102 may vary, depending upon the size of substrate 102 and the size of each integrated circuit chips 112. Further, the number of balls in each ball grid array 110 may also vary. By way of example, as shown, substrate 102 includes one hundred and forty integrated circuit chips 112, each of which have a ball grid array with sixteen balls.

Substrate 102 also generally includes locator holes 106 which are used for various fabrication processes including, but not limited to, processes used to apply ball grid array 110 on chips 112 and processes used to encapsulate substrate 102. "Pick-up points" 116, which are also included on substrate 102, are arranged to enable cameras to check the overall alignment of substrate 102, as necessary, during fabrication.

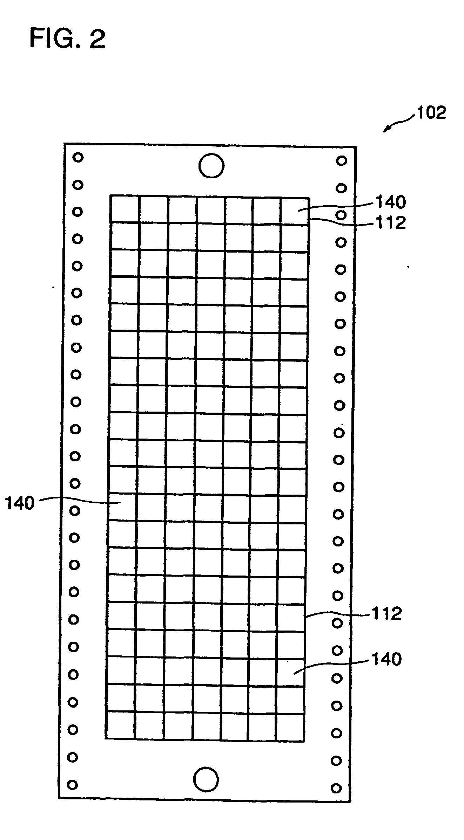

A representation of the non-BGA side of substrate 102 is shown in Fig. 2. Non-BGA side of substrate 102 may be considered to be "die-side" of substrate 102, as non-BGA side typically includes integrated circuit dies 140. As will be appreciated by those skilled in the art, when substrate 102 is diced to form individual integrated circuit chips 112, on side of each integrated circuit chip 112 will have ball grid array 110, while the other side will have integrated circuit due 140.

As mentioned above, in order to separate integrated circuit chips from a substrate, the substrate must be diced with a dicing saw or similar device. Typically, a dicing process involves manually placing the substrate, non-BGA side down, on an adhesive surface, e.g., tape. The tape is arranged to hold the individual integrated circuit chips in place, both during and after dicing. Specifically, the tape is used to prevent the individual integrated circuit chips from rotation and translation with respect to one another.

A substrate is cut from the BGA side, i.e., a substrate is cut with the non-BGA side down, since it is difficult for tape to effectively grip and hold the balls in ball grid arrays, either from the bottom surfaces of the balls or from the side surfaces of the balls. In other words, while tape is capable of securely holding a substantially smooth surface such as the dies on a substrate during dicing, the tape is not as effective in securely holding an uneven surface, such as the overall surface of ball grid arrays, during dicing.

Once a substrate is placed on tape with the BGA side up, the tape and the substrate are manually loaded on a vacuum chuck for dicing. In other words, the tape and the substrate are aligned on a vacuum chuck, tape-side down, such that the vacuum from the vacuum chuck effectively "grips" the tape and the board. While the tape and the substrate are held on the vacuum chuck, a dicing saw is used to automatically dice the integrated circuit chips. As will be appreciated by those skilled in the art, the dicing saw dices the substrate to form the integrated circuit chips, substantially without cutting through the tape.

Once the integrated circuit chips are separated, the chips must be removed from the tape. A vacuum is generally not used to remove the chips from the tape, since the chips are often not accurately aligned on the tape. Typically, a person may remove each chip, BGA side up, from the tape, then place each chip, BGA side down, in a holding tray which may be used to transport the chips to a subsequent fabrication process. The use of manual processes, however, is often time-consuming and inaccurate.

Alternatively, in lieu of a manual process, a pick-and-place machine may be used to remove the chips from the tape, and place the chips in holding trays. As was the case with manually removing chips from the tape, the use of pick-and-place machines is often time consuming. By way of example, a pick-and-place machine must line up each chip prior to picking that chip off the tape. In addition, pick-and-place machines are additional pieces of fabrication equipment that are generally separate from dicing machines. Therefore, an overall dicing process is likely to require an additional manual process of transporting the tape and the diced chips to the pick-and-place machine.

The use of tape in dicing processes is often undesirable as the tape may be relatively expensive, and must be disposed of once the dicing process is completed. In addition, adhesives on the tape may remain on a chip after the dicing process, thereby creating residue that may be difficult to remove. When residue is not properly removed from a chip, subsequent fabrication steps, as well as the integrity of the chip, may be compromised. The use of tape also generally requires manual handling, e.g., placing a substrate on tape. As will be appreciated by those skilled in the art, in addition to being both tedious and time consuming, manual processes often increase the likelihood that a substrate may be mishandled or become contaminated. US-A-5803797 discloses an apparatus and a method for cutting a tapeless substrate.

### SUMMARY OF THE INVENTION

The object of the present invention is to provide an arrangement configured to support a substrate during a dicing process which enables to securely hold the substrate for efficiently and substantially automatically dicing the substrate to form individual integrated circuit chips, without the use of tape during the dicing process.

In order to solve the aforementioned problems, an arrangement configured to support a substrate during a dicing process according to the present invention has a structure as follows. First, the substrate to be supported has a first substrate side and a second substrate side, and the first substrate side is smoother than second substrate side. The arrangement comprises a nest having a first nest side and a second nest side and a vacuum retainer plate having thereon at least one vacuum pedestal. The nest includes a grid which defines at least one nest opening and the vacuum pedestal is configured to be disposed through the nest opening when the nest is mated with the vacuum retainer plate. The nest opening has an opening area that is smaller than an area of a die diced from said substrate.

The vacuum pedestal has an upper surface formed of a resilient material and protrudes above the first nest side of the nest when the vacuum pedestal is disposed through the nest opening from the nest side to lift the substrate off the first nest side when the substrate is positioned on the nest with the first substrate side facing the first nest side and when the nest is mated with the vacuum retainer plate.

In using the arrangement, the substrate is diced when the substrate is lifted off the first nest side of the main nest body while the nest is mated with the vacuum retainer plate.

According to a preferred embodiment of the present invention, the vacuum pedestal includes a vacuum port configured to hold the die securely against an upper surface of the vacuum pedestal when the nest is mated with the vacuum retainer plate and vacuum is turned on.

Preferably, the vacuum pedestal further includes a countersunk portion disposed in the upper surface, the countersunk portion is in vacuum communication with the vacuum port, and the diameter of the countersunk portion is larger than a diameter of the vacuum port.

According to another preferred embodiment of the present invention, the nest opening further has at least one retainer wall disposed on the first nest side proximate the opening area.

According to yet another preferred embodiment or the present invention, the vacuum retainer plate further comprises a channel disposed between adjacent vacuum pedestals of the vacuum retainer plate and the channel is arranged to receive a saw blade during the dicing process.

Besides the arrangement described above and not being part of the present invention, a cutting apparatus for a tapeless substrate comprises a supporting mechanism for retaining the tapeless substrate (102) not having on its back surface a tape for adhesion, a vacuum retaining mechanism for engaging the substrate retained within the supporting mechanism with a vacuum, and a cutting mechanism for cutting a prescribed portion of the tapeless substrate retained within the nest mechanism and engaged with the vacuum, wherein the vacuum retaining mechanism is so structured that the tapeless substrate is resiliently retained with vacuum within the supporting mechanism with a resilient member interposed therebetween.

Further to the above, a method for cutting a tapeless substrate comprises the steps of: resiliently retaining the tapeless substrate not having on its back surface a tape for adhesion with vacuum by interposing a resilient material, and, cutting a prescribed portion of the tapeless substrate resiliently retained with vacuum.

These and other advantages of the present invention will become apparent upon reading the following detailed description, and studying the various figures of the drawings.

### BRIEF DESCRIPTION OF THE DRAWINGS

Fig. 1 is a diagrammatic representation of a ball grid array side of a conventional substrate.
Fig. 2 is diagrammatic representation of a die side of the conventional substrate of Fig. 1.
Fig. 3 is a diagrammatic top-view representation of a nest for supporting a substrate during a dicing process.
Fig. 4 is a diagrammatic perspective representation of the nest of Fig. 3.
Fig. 5 is a process flow diagram with illustrates the steps associated with forming individual chips from a substrate in accordance with the present invention.
Fig. 6 is a diagrammatic top-view representation of another nest.
Fig. 7 is a diagrammatic top-view representation of yet another nest.
Fig. 8 is a diagrammatic perspective representation of a nest in accordance with the present invention.
Fig. 9 is a diagrammatic perspective representation of a vacuum retainer plate increasing a vacuum block platform and a base plate in accordance with the present invention.
Fig. 10 is a diagrammatic close-up representation of retainer walls substantially surrounding a nest opening in accordance with the present invention.
Fig. 11 is a process flow diagram which illustrates the steps associated with forming individual chips from a substrate in accordance with the present invention.
Figs. 12 and 13 depict, in accordance with the present invention, a vacuum block platform, which includes a vacuum pedestal base and a vacuum pedestal portion.
Fig. 14 illustrates, in accordance with the present invention, an exemplary clamp for attaching a vacuum pedestal portion to a vacuum pedestal base.
Fig. 15 illustrates, in accordance with the present invention, a top view of a representative vacuum pedestal.

### DESCRIPTION OF THE PREFERRED EMBODIMENTS

The present invention will now be described in detail with reference to a few preferred embodiments thereof as illustrated in the accompanying drawings. In the following description, numerous specific details are set forth in order to provide a thorough understanding of the present invention. It will be obvious, however, to one skilled in the art, that the present invention may be practiced without some or all of these specific details. In other instances, well known structures and process steps have not been described in detail in order not to unnecessarily obscure the present invention.

A nest apparatus is arranged, in conjunction with a vacuum, to securely hold a substrate during a dicing process with use of tape. A substrate is placed, ball grid array (BGA) side down, into a nest which is then mounted on a vacuum chuck for dicing. During dicing, the nest and the vacuum effectively constrain the substrate and, subsequently, the individual chips formed by dicing the substrate, from translational and rotational movement. When the nest and the diced chips are removed from the vacuum chuck after dicing, the diced chips are essentially ready to be removed from the nest, as for example using a pick and place machine.

### (First Embodiment)

In accordance with a first embodiment of the present invention, a nest apparatus is arranged, in conjunction with a vacuum retainer plate arrangement, to securely hold a substrate during the dicing process without the use of tape. The substrate is placed, ball grid array (BGA) side up, into a nest which is then mounted on the vacuum retainer plate for dicing. By mounting the nest on the vacuum retainer plate, vacuum pedestals on the vacuum retainer plate protrude through the nest opening to raise the substrate above the upper surface of the nest. The top surface of the vacuum pedestal also forms a vacuum seal with the smooth undersurface of the die to be cut, allowing the die to be held securely to the top surface of the vacuum pedestal when the vacuum is turned on. Because the substrate is raised slightly above the top surface of the nest, the die saw may protrude below the thickness of the substrate without risking damage to either the nest or the saw blade. During cutting, the saw is disposed within channels which are present between vacuum pedestals in the vacuum retainer plate. The recessed channels may be sized to permit some degree of fluctuation in side to side placement of the saw. Increasing the width of the channels will decrease the top surface area of each vacuum pedestal, but that will not significantly impact the ability of the vacuum to hold the cut die on top of the vacuum pedestal.

After the substrate is cut, a top cover is then placed over the nest containing the cut dies of the substrate. The top cover preferably has contact posts which hold down each individual die. This combination of the top cover, the nest and the cut dies in between forms a covered nest fixture, which is then lifted off the vacuum block platform. By lifting the covered nest fixture from the vacuum block platform, the individual dies are permitted to drop back down to the nest surface. More specifically, each nest opening has retainer walls disposed adjacent to its opening. When each cut die drops down to rest on the top surface of the nest, the retainer walls securely hold each cut die by their edges, thereby preventing the translational and rotational motion of the cut die. The cut die, being held substantially immobile by the retainer walls, as well as trapped between the contact posts of the top cover and the nest, may now be further processed (e.g., washing, rising, drying) while being kept substantially immobile. Since each cut die is held substantially immobile on the surface of the nest by the retainer walls, the diced chips are essentially aligned and ready to be removed from the nest when the top plate is removed, as for example, using a pick and place machine. In this manner, the overall dicing process is automated and the cut dies are held immobile during cutting, transporting, and subsequent processing without the use of tape as well as aligned for subsequent picking and placing.

The use of a nest to hold a substrate during dicing, without tape, eliminates problems associated with adhesive residue left on chips by the tape, as well as issues associated with disposing of the tape. Using a nest also allows the overall dicing process to be more automated, as the need for manual processes including mounting a substrate on a vacuum chuck and removing chips from the tape may be eliminated.

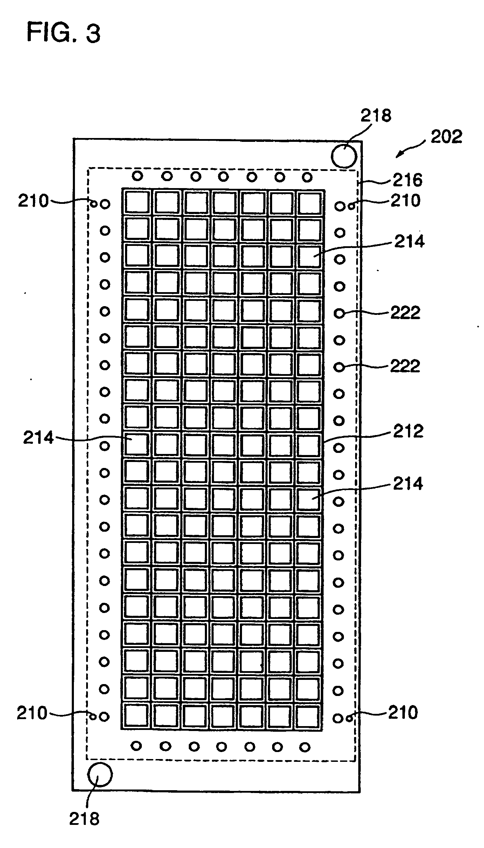

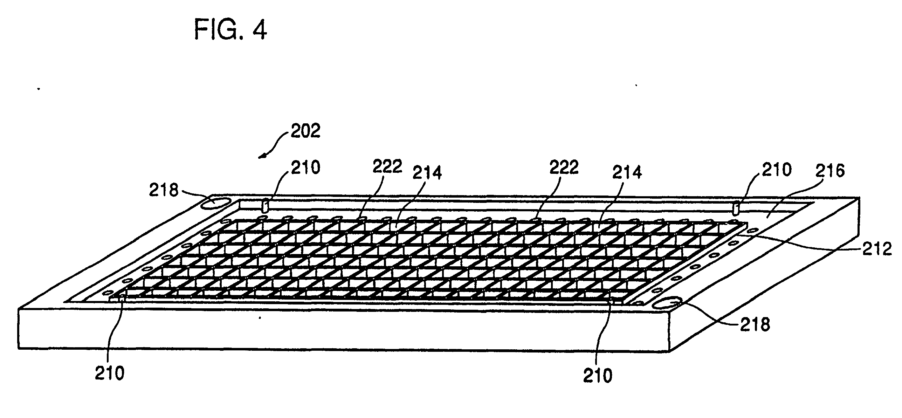

Referring to Figs. 3 and 4, a nest mechanism will be described. Fig. 3 is a diagrammatic top-view representation of a nest mechanism, while Fig. 4 is a substantially perspective representation of the nest mechanism. It should be appreciated that for ease of illustration, Figs. 3 and 4 are not drawn to scale. A nest 202 is configured, or otherwise arranged, to translational and rotational reduce the movement of a substrate positioned within nest 202. While nest 202 may be made of a variety of different material, it is fabricated from stainless steel, due to the fact that stainless steel is both lightweight and strong. By way of example, nest 202 may be fabricated from 400C stainless. Alignment pins 210 on nest 202 are used to engage locator holes on a substrate in order to position the substrate with respect to nest 202. In general, substantially any suitable mechanism may be used to align a substrate with nest 202.

When a substrate is properly positioned with respect to nest 202, the substrate rests against a grid arrangement 212. Although the die side of a substrate may be placed "face down" on nest 202, the BGA side of the substrate is placed onto nest 202. Grid arrangement 212 defines opening 214 which accommodate the ball grid arrays of a substrate. That is, the ball grid arrays of the substrate are at least partially placed within opening 214. As shown, while grid arrangement 212 defines one hundred and forty opening 214, the number of openings 214 may typically be widely varied.

Each opening 214 effectively "holds" one ball grid array such that at least one of the balls, or contact, of the ball grid array 110 lightly contact the walls of grid arrangement 212. The sides of four "corner" balls of a ball grid array may contact the corners of grid arrangement 212 in each opening 214. As such, while opening 214 may be substantially rectangularly shaped, the corners of opening 214 may be slightly curved to facilitate contact of only the sides of corner balls against grid arrangement 212. It should be appreciated, however, that substantially all balls along the sides of each ball grid array may contact the walls of grid arrangement 212.

Nest 202 may be mounted against a vacuum chuck that is a part of a dicing saw assembly. The vacuum chuck typically generates a vacuum which engages the substrate mounted on nest 202 through opening 214. Generally any suitable mechanism may be used to mount nest 202 against a vacuum chuck, including, but not limited to, pilot locator holes 218 which are arranged to fit over dowels, or similar structures, on the vacuum chuck.

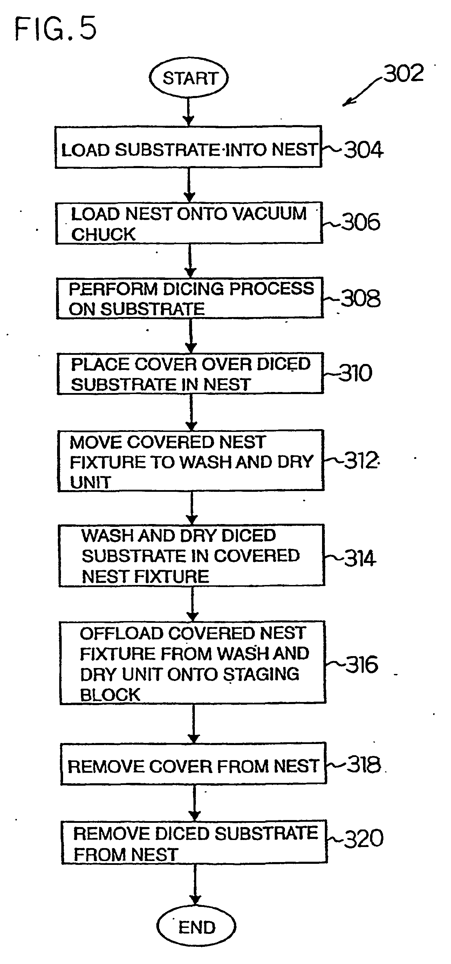

As will be described below with respect to Fig. 5, when nest 202 and, hence, a substrate, are mounted on a vacuum chuck, a dicing saw may then cut the substrate to generate separate integrated circuit chips from the substrate. Nest 202 is effective to hold the separate integrated circuit chips substantially in place by locating the balls of the ball grid array of each chips. The vacuum from the vacuum chuck holds each chip against grid arrangement 212, while the contact between the sides of at least one of the balls of the chip and the walls of grid arrangement prevents the chip from rotating and translating. By preventing chips from rotating and translating, subsequent pick and place processes used to remove chips from nest 202 may be efficiently accomplished. Further, preventing chips from freely moving during and after dicing also reduces the likelihood that dicing process may inaccurately cut the chips from the substrate.

As shown, a stepped section 216, or channeled section, is arranged to receive the cut sides of the substrate after the substrate has been cut, or diced. In other words, scrap material from the substrate falls into stepped section 216, and, as a result, is effectively prevented from migrating with respect to nest 202, and potentially negatively affecting dicing processes. Vacuum opening 222 may be used, in addition to stepped section 216, in order to further prevent scrap material from migrating during and after a dicing process. Specifically, vacuum generated by a vacuum chuck may engage the scrap material through vacuum opening 222, thereby essentially forcing the scrap material to remain within stepped section 216.

With reference to Fig. 5, one method of implementing the nest of Fig. 3 and 4 in the creation of individual chips from a substrate will be described. Fig. 5 is a process flow diagram which illustrates the steps associated with forming individual chips from a substrate in accordance with an embodiment of the present invention. The process 302 begins in step 304 in which a substrate to be diced is loaded into a nest. In general, loading a substrate into a nest includes aligning the substrate with respect to the nest to properly position the substrate. As described above, aligning the substrate with reference to the nest includes positioning the substrate schematic that alignment pins on the nest interface with locator holes on the substrate. When the substrate is properly aligned, the balls in each ball grid array located on the BGA side of the substrate are effectively positioned in the nest openings of the nest.

After the substrate is loaded into the nest in step 304, the nest is loaded onto a vacuum chuck in step 306. Specifically, the nest is automatically loaded onto the vacuum chuck such that the BGA side of the substrate is in communication with the vacuum provided by the vacuum chuck. In other words, the nest is positioned to enable the suction from the vacuum to effectively engage the BGA side of the substrate. As will be appreciated by those skill in the art, the vacuum chuck may be a part of an overall dicing saw assembly that is arranged to dice the substrate into individual chips.

When the nest is loaded onto the vacuum chuck, then in step 308, a dicing process is performed on the substrate. In other words, the dicing saw, e.g., a diamond wheel, of the dicing saw assembly is used to cut the substrate to form individual chips. After the dicing process is completed, process flow moves to step 310 in which a cover is placed over the nest. The cover is arranged to prevent the individual chips from moving once the nest is removed from the vacuum chuck. The cover is arranged with protrusions which lightly press against the non-BGA side of the individual chips to hold portions of the BGA side of the individual chips against the nest. It should be appreciated, however, that the cover is generally not arranged to hold scrap material, e.g., extra material which is left at the sides of the substrate after individual chips are formed. Rather, the cover may be arranged to allow the scrap material to be washed out of the nest, as will be described below.

The covered nest fixture is removed from the vacuum chuck in step 312, and moved to a "wash and dry" unit. The covered nest fixture is automatically removed from the vacuum chuck, and moved to the wash and dry unit. A wash and dry unit may be a part of the overall dicing saw apparatus, and is generally arranged to remove residue left during the dicing process from the individual chips. The wash and dry unit is further arranged to dry the chips once they have been cleaned. In general, a wash and dry unit is arranged to remove dirt, debris, and dust that has accumulated during the dicing process.

In step 314, the diced substrate is washed and dried in the covered nest fixture. During a process, the BGA side of the chips is effectively either sprayed with fluid, e.g., water, through the nest openings in the nest, or submerged in fluid. In addition to washing the chips, the spraying of fluid, as well as the submerging of the nest in fluid, is also effective to remove the scrap material from the nest. In other words, the scrap material is allowed to "float" out of the nest during washing, as the scrap is not held within the covered nest fixture. The wash and dry unit may be arranged to capture scrap material and residue such that the scrap material and residue may be readily removed from the wash and dry unit.

After the chips are washed and dried, the covered nest fixture is offloaded from the wash and dry unit in step 316. The covered nest fixture is automatically offloaded onto a staging block. Once the covered nest fixture is offloaded, then in step 318, the cover is removed, thereby exposing the diced substrate, or individual chips. Finally, in step 320, the chips are removed from the nest. Typically, the chips are removed from the nest such that they may be placed in trays for further processing. While substantially any suitable method may be used to remove the chips, methods include using a pick and place machine to remove the chips from the nest. The pick and place machine is a part of the overall dicing saw assembly. That is, a single apparatus may be used to both dice the substrate into individual integrated circuit chips and to remove the diced chips from the nest. However, it should be appreciated that the pick and place machine may, alternatively, be separate from the dicing saw assembly. When the chips are removed from the nest, the process of forming individual chips is completed.

As shown in Fig. 3, a nest may be rectangularly shaped such that the nest is arranged to accommodate substantially rectangularly shaped substrate. In general, however, it should be appreciated that the configuration of a nest may vary widely. For example, the overall size and shape of a nest may change, depending upon the size and the shape of the substrates that the nest is intended to support. Further, the size and the shape of openings in a nest, i.e., nest openings, through which the balls on a substrate may at least partially protrude, as described above with respect to Fig. 3, may vary depending upon the number of and orientation of balls on the substrate or, more specifically, each chips on the substrate. As such, the grids of the nest support the substrate, which are arranged to provide minimal contact on the balls as necessary to support the substrate during a dicing process, may take on different orientations.

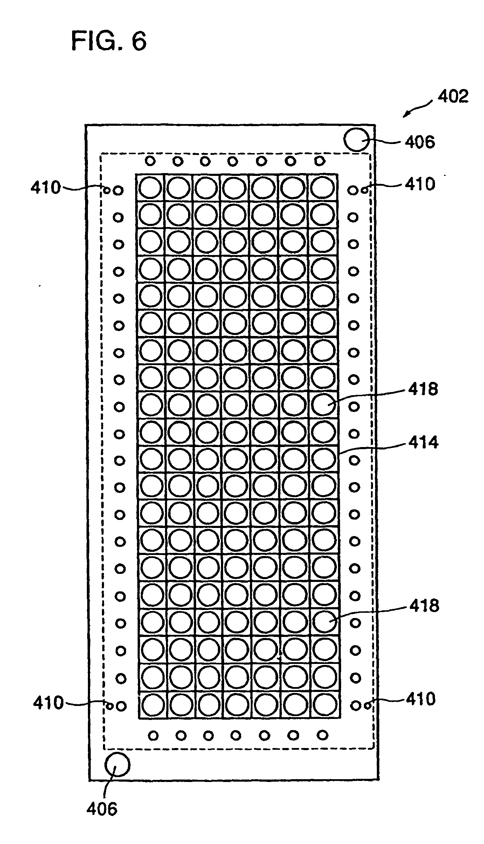

Fig. 6 is a diagrammatic top-view representation of another nest. Like nest 202 of Figs. 2a and 2b, a nest 402 includes pilot locator holes 406, which may be used to hold nest 402 against a vacuum chuck. Nest 402 also includes alignment pins 410 which, as described above, are arranged to align a substrate with respect to nest 402. A grid 414 defines nest openings 418 which are substantially circular in shape. Circularly shaped nest openings 418 may accommodate ball grid arrays which have a circular footprint. In other words, each circularly shaped nest opening 418 may be arranged to accommodate a ball grid array in which the balls are arranged in a substantially circular pattern. Alternatively, each circularly shaped nest opening 418 may be arranged to accommodate a ball grid array with a polygonal, e.g., rectangular, footprint.

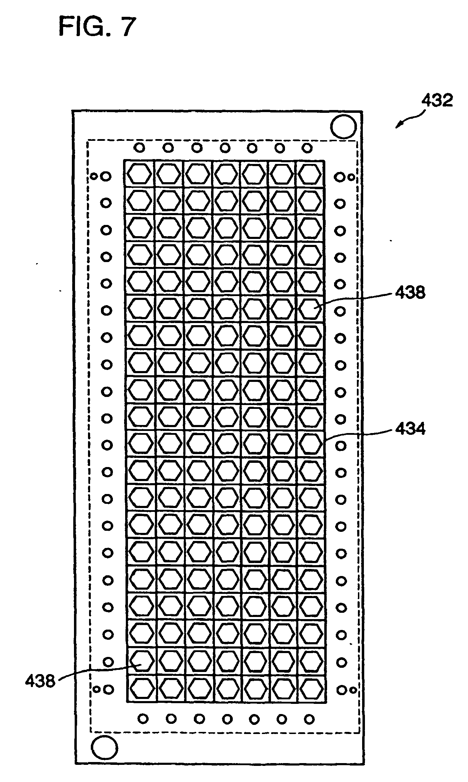

Fig. 7 is a diagrammatic top-view representation of still another nest. A nest 432 includes a grid 434 that effectively defines nest openings 438. As shown, nest openings 438 are polygonal in shape. Specifically, the nest openings 438 are hexagonal in shape.

Nest openings 438 are arranged such that they may accommodate ball grid arrays which have a footprint which is of substantially the same shape as nest openings 438. It should be appreciated, however, that nest openings 438 may be suitable for accommodating ball grid array which have a different footprint than that of nest openings 438. For example, hexagonally shaped nest openings 438 may accommodate ball grid arrays which are arranged in a substantially rectangular orientation. Alternatively, hexagonally shaped nest openings 438 may also accommodate ball grid arrays which are shaped in a substantially triangular orientation.

### (Second Embodiment)

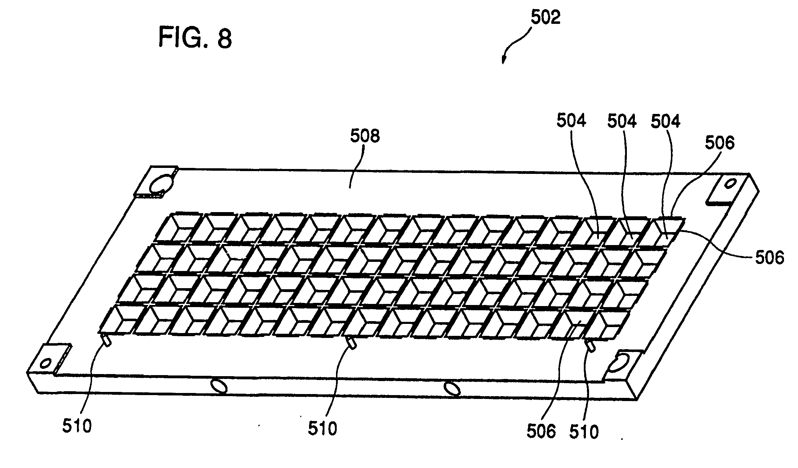

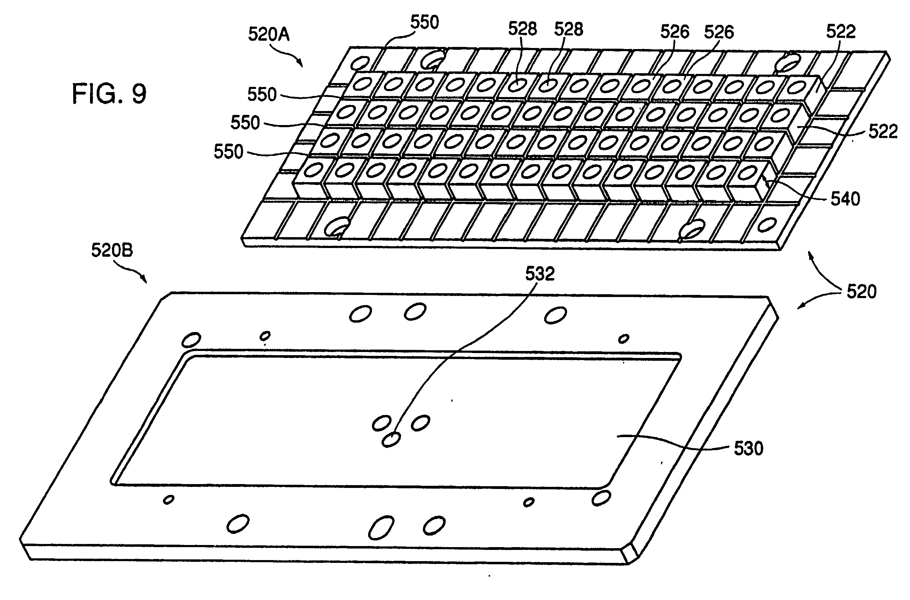

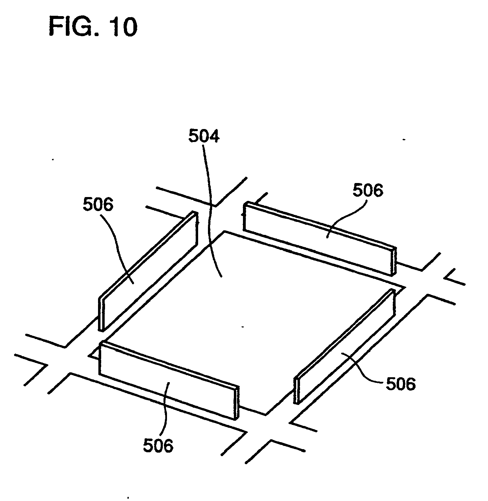

Fig. 8 and 9 illustrate in accordance with a second embodiment of the present invention, a combination vacuum retainer plate/nest mechanism which permits dicing to be performed with the BGA side of the substrate facing up. With reference to Fig. 8, nest 502 includes a plurality of nest opening 504, which are formed through the thickness of nest 502. The size of each nest opening 504 is dimensioned to be slightly smaller than the dimension the cut die to prevent the cut die from falling through. Each nest opening 504 is surrounded at its opening by retainer walls 506, which are disposed on top surface 508 of nest 502. Retainer walls 506 are arranged such that a cut die can rest on top surface 508 of nest 502 while overlying nest opening 504, yet have its edges retained within wall 506 to limit the translational and rotational movement of the individual cut die. Exemplary retainer walls 506 may be more clearly seen in Fig. 10. A plurality of locator pins 510 are shown, which may be employed to align the substrate prior to cutting to nest 502.

Nest 502 is configured to mate with a vacuum retainer plate 520. In the example of Fig. 9, vacuum retainer plate 520 includes a vacuum block platform 520A and a base plate 520B. Vacuum block platform 520A includes a plurality of raised vacuum pedestal 522. Electron vacuum pedestal 522 is configured to fit within a nest opening 504 of nest 502. Each vacuum pedestal 522 also includes a pedestal top surface 526 which is flat to form a vacuum seal with the under surface of the cut die during cutting. Each vacuum pedestal 522 further includes a vacuum port 528. When vacuum block platform 520A is mounted on baseplate 520B, vacuum port is connected to a recessed chamber 530 in baseplate 520B. When a vacuum exists within recess chamber 530, as for example when vacuum lines are connected to port 532 in baseplate 520B, each vacuum port 528 of vacuum pedestal 522 provides vacuum to hold down the cut die during the cutting period.

When nest 502 having thereon a substrate to be cut is mounted on vacuum retainer by placing nest 502 on top of vacuum block platform 520A, the vacuum pedestals 522 protrude through nest openings 504 of nest 502. The height 540 of each vacuum pedestal 522 is dimensioned such that pedestal top surface 526 protrudes above top surface 508 of nest 502 when nest 502 is mated atop vacuum block platform 520A. Accordingly, the substrate lifted off top surface 508 of nest 502 by pedestal top surface 526. Therefore, the height of retainer walls 506 are typically lower than the height at which the top surface of the vacuum pedestal protrudes above the top surface of the nest when the nest is mated on top of the vacuum block platform. For example, if the top surface of the vacuum pedestal protrudes above the top surface of the nest by about 0.25mm (10mil) to lift the surface off the top surface by about 0.25mm (10mil), the height of the retainer wall may be about 0.125 mm (5mil). Therefore, vacuum is turned on to allow vacuum port 528 to securely hold down the substrate by the bottom surfaces of the individual dies. After the vacuum is turned on, the substrate may be cut. Since the substrate is physically lifted off top surface 508 of nest 502, there is little risk of damage to the saw or top surface 508 of nest 502 during cutting. Furthermore, the height 540 of vacuum pedestal 522 may be adjusted to increase or decrease the distance from which the substrate is lifted off top surface 508 of nest 502 as desired. The height of the retainer walls 506 may also be adjusted as desired.

Adjacent vacuum pedestals 522 are separated by a recessed channel 550. This recessed channel may be much wider than the width of the saw, thereby allowing some flexibility and tolerance in saw blade placement during cutting. In one example, the width of recessed channel 550 may range from between about 0.15mm (6mil) to about 0.3mm (12mil) permitting the saw blade to move from side to side as much as about 0.125mm (5mil) without risking damage to the blade. Although it was not shown in Fig. 8, the step portion and/or vacuum port may be around the array nest opening to retain the scrap parts to facilitate their removal during subsequent washing or rinsing.

After cutting, the vacuum is left on and a top cover, which is not shown in the figures, is placed on top of nest 502 and the cut die. The combination of the top cover, cut die, and nest 502 forms a covered nest fixture. Since the vacuum is left on, each individual cut die is still held securely on pedestal top surface 526 of vacuum pedestal 522 at this point. The top cover preferably has a plurality of contact posts to contact designated locations on each cut die (e.g., the four corners of the cut die) to hold the cut die down by the weight of the top cover. Thereafter, the covered nest fixture is lifted off vacuum retainer plate 520. Since individual cut die are no longer lifted off top surface 508 of nest 502, they drop down or are forced downward by the weight of the top cover to rest on top surface 508 and are constrained by retainer walls 506. In this manner, the top cover and top surface 508 trap each cut die in between while retainer walls 560 substantially limit the rotational and translational movement of the individual cut die. Thereafter, the covered nest fixture may be transported to a washing/rising/drying machine. Since each individual cut die is constrained by top surface 508 and retainer walls 506, the individual cut die are aligned for subsequent processing once the top cover is lifted off nest 502.

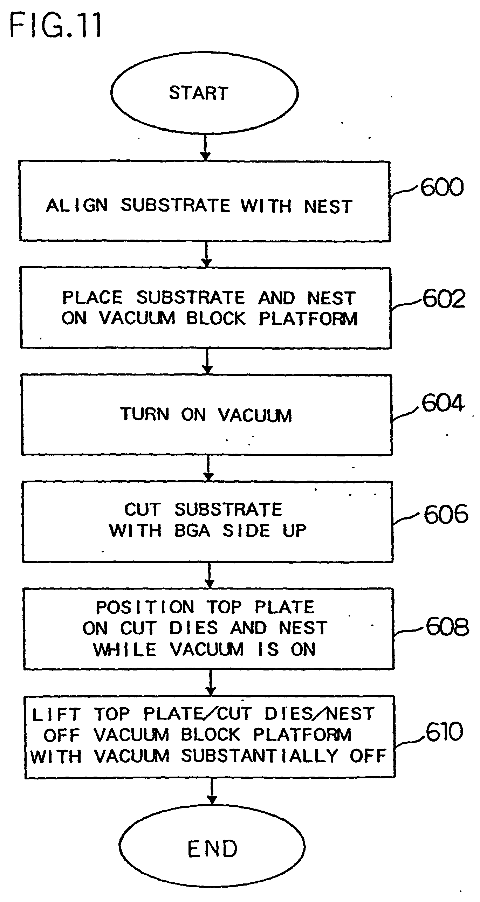

Fig. 11 illustrates, in accordance with the present invention, a flow chart of the automated die cutting technique using the nest and vacuum retainer plate arrangement of Figs. 8 and 9. In step 600, the substrate is aligned to the retainer nest, BGA side up and side down. In one embodiment, the substrate is aligned to the nest by the locator pins on the nest (such as locator pin 510 on nest 502 of Figs. 8 and 9).

In step 602, the combination of the nest and substrate to be cut is positioned on top of the vacuum block platform to allow the top surface of the vacuum pedestal to lift the substrate off the top surface of the nest. In step 604, the vacuum is turned on to securely hold the substrate to the pedestal top surfaces of the vacuum block platform. In step 606, the substrate is cut with the BGA side up. One advantage of this implementation is that the die can be cue with a plastic or the molded side down, which is more forgiving towards the end of the cut.

In step 608 the top cover is placed on top of the cut dies and the nest while the vacuum is on. As mentioned earlier, the weight of the top cover holds the cut dies in place and forces the cut dies downward when the covered nest fixture is lifted from the vacuum block platform (step 610).

As mentioned earlier, when the covered nest fixture is lifted from the vacuum block platform, the individual cut dies fall down or are forced downward by the top cover toward the top surface of the nest to allow each individual cut die to be trapped between the plate and the top surface of the nest, with the sides of each cut die constrained by the retainer walls disposed around the nest opening. Thereafter, the dies may be further processed while being constrained between the top cover and the nest and by the retainer walls (e.g., washing, rinsing, drying and the like). Thereafter, the top cover may be lifted off the allow pick and place equipment to access the cut dies, which are now disposed on the top surface of the nest and constrained by the retainer walls, thereby aligned for the pick and place operation.

In accordance with the present invention, vacuum pedestals 522 are formed a resilient material that readily conforms to the undersurface of the cut die. Preferably, the resilient material of vacuum pedestals 522 is also at least slightly compressible to improve the seal that is formed between pedestal top surface 526 and the substrate when the substrate is disposed on pedestal top surface 526 and the vacuum is turned on. The resilient material of the vacuum pedestals, being softer, also has the advantage of being less likely to damage the saw blade should the saw blade inadvertently come into contact with the vacuum pedestals during dicing.

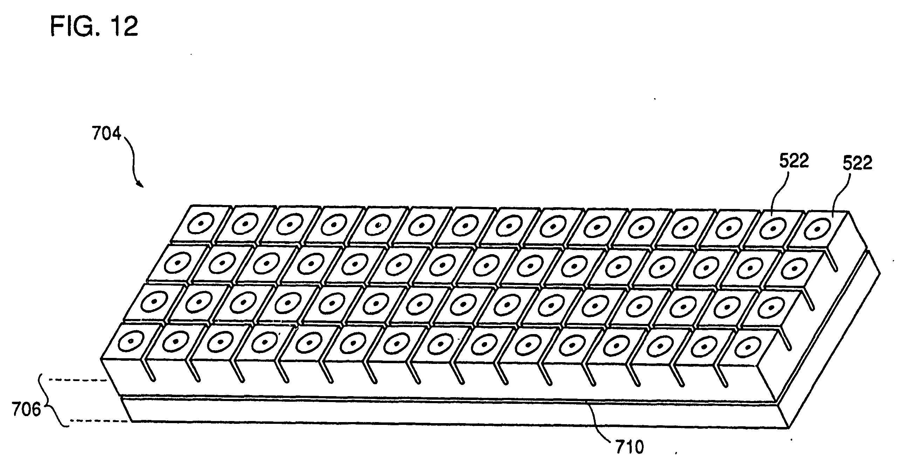

Figs. 12-15 illustrate in accordance with the present invention, wherein a synthetic or natural rubber material that is capable of withstanding the rigors of repeated cutting and rising cycles is employed. By way of example, it is preferable that the vacuum pedestal material chosen be sufficient durable to minimize contamination to the cutting and rising process. Alternatively or additionally, it is preferable that the vacuum pedestal material chosen be able to withstand, for a commercially satisfactory number of cycles, the de-ionized water rising process that may be employed after cutting. Alternatively or additionally, it is preferable that the vacuum pedestal material possess anti-static properties to prevent damage to the integrated circuits being fabricated. Alternatively and additionally, it is preferable that the vacuum pedestal material possess a high friction coefficient relative to the undersurface of the substrate to prevent translational and/or rotational movement of the substrate and/or the individual dies during and after cutting. Alternatively or additionally, it is preferable that the vacuum pedestal material be machinable to simplify its manufacturing.

In a preferred embodiment, a synthetic material known by the trade-name "VITON" (available from McDowell & Company of Downey, CA or Pacific State Felt & Mfg. Co. Inc. of Hayward CA) is employed. The resilient VITON material, in addition to being conformable and/or compressible, also offers substantial advantages with respect to machinability, high friction, anti-static property, relative inertness to the rinsing chemicals, and general durability when employed in the vacuum pedestal application.

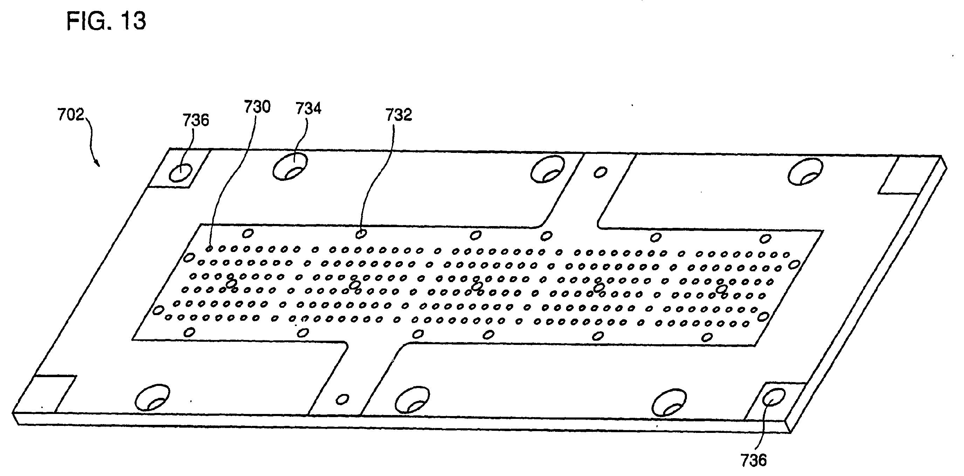

With reference to Figs. 12 and 13, a vacuum block platform 520A preferably includes a vacuum pedestal base 702 and a vacuum pedestal portion 704. Vacuum pedestal portion 704 includes a bridge portion 706, which is coupled to the individual vacuum pedestals 522 to provide mechanical support therefor. In one embodiment, both bridge portion 706 and the individual pedestals 522 of vacuum pedestal portion 704 are formed from the same block of resilient material. Machining is a preferred method for forming such a vacuum pedestal portion due to cost and ease of manufacturing considerations. However, any other suitable manufacturing techniques, such as molding, may also be employed to form vacuum portion 704.

Vacuum pedestal base 702 may be formed from any suitable material, including metal such as stainless steel. Vacuum base 702 includes a plurality of vacuum ports 730, which are configured to be in communication with the vacuum ports disposed within individual vacuum pedestals 522 of vacuum pedestal portion 704. Vacuum pedestal base 702 may be coupled to vacuum pedestal portion 704 using any suitable technique, including the use of adhesives or clamping. With reference to Fig. 12, vacuum pedestal portion 704 includes groove 710 to permit a clamp to be inserted therein for the purpose of coupling vacuum pedestal base 702 to vacuum pedestal portion 704. In the example of Fig. 13, screw holes 732 are provided in vacuum pedestal base 702 to allow the clamps to be attached thereto. Fig. 13 also shows additional screw holes 734, which facilitate the coupling of vacuum pedestal base 702 to an appropriate base plate, such as base plate 520B or a simply suitable base plate. Alignment pin holes 736 are provided to accommodate alignment pins, which are employed to align a nest, such as nest 502, with the vacuum block platform during dicing.

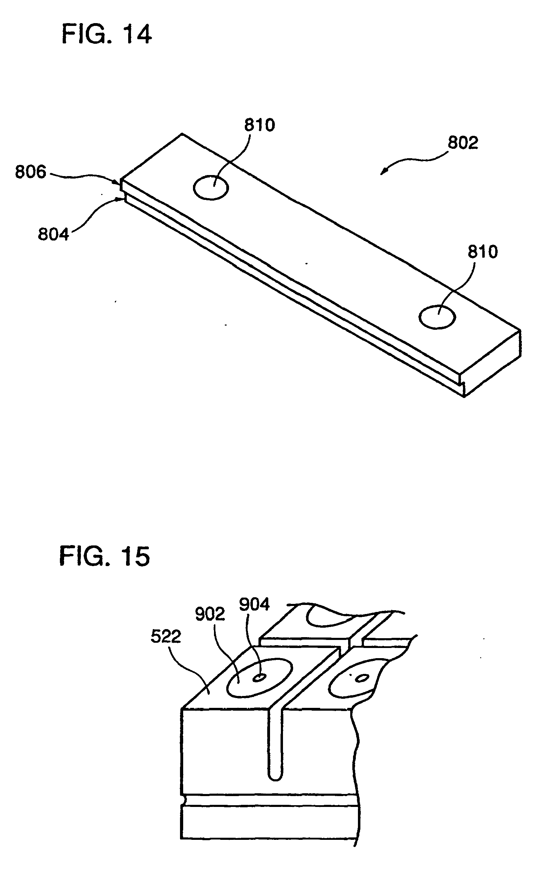

Fig. 14 illustrates one exemplary clamp 802, including a base 804 and a tongue 806. When tongue 806 of clamp 802 is disposed within groove 710 of vacuum pedestal portion 704, base 804 may be coupled to the upper surface of vacuum pedestal base 702, for example, to fix vacuum pedestal portion 704 atop vacuum pedestal base 702. Note that base 804 of clamp 802 may be coupled to vacuum pedestal base 702 using any suitable technique, including for example, the use of adhesive or fasteners. In the example of Fig. 14, screw holes 810 are provided to accommodate screws, which are then screwed into screw holes 732 to fasten the clamp 802/vacuum pedestal portion 704 assembly with vacuum pedestal base 704. Clamping vacuum pedestal base 702 to vacuum pedestal portion 704 in this manner also advantageously permits vacuum pedestal portion 704 to be readily replaceable when worn.

Fig. 15 illustrates a top view of a vacuum pedestal 522 in accordance with the present invention. Each vacuum pedestal 522 preferably includes a countersunk portion 902, which is in communication with a vacuum port 904 disposed within vacuum pedestal 522. The cross-sectional area of countersunk portion 902 is preferably suitably dimensioned to allow the vacuum to develop a sufficient holding force to properly secure an individual die atop vacuum pedestal 522 during cutting while leaving enough of the top surface of vacuum pedestal 522 remaining to maintain proper sealing and frictional contact with the undersurface of the die.

In the embodiment of Figs. 12 and 13, the aforementioned resilient material is employed to form a substantial portion of the height of the individual vacuum pedestals above bridge portion 706. In another embodiment, the resilient material may take the form of a resilient capping arrangement that is disposed atop the vacuum pedestals. That is, at least a portion of the individual vacuum pedestal above bridge portion 706 may be formed of a material other than the resilient material (e.g., metal or hard plastic), either integrally with bridge portion 706 or separately but in a sealing relationship therewith. The resilient capping arrangement formed of the resilient material may take the form of a sheet of resilient material or individual pedestal caps having holes therein to accommodate the vacuum port of the vacuum pedestal. In one embodiment, the holes are dimensioned to provide the desired cross-sectional area (and therefore the desired vacuum pedestal), thereby eliminating the need to machine the top surface of the vacuum pedestal to form the aforementioned countersunk portion. The resilient capping arrangement may be secured to the top surface of the vacuum pedestals of this embodiment using any suitable technique, including friction fit, clamping and/or the use of adhesives.

Although only a few embodiments of the present invention have been described, it should be understood that the present invention may be embodied in many other specific forms. By way of example, it is possible to omit the vacuum pedestal base and to attach the vacuum pedestal portion 704 directly to the base plate of the vacuum retainer plate if the vacuum retainer plate has the appropriate vacuum arrangement to provide vacuum to the vacuum ports within the vacuum pedestal portion. Such modification is within the skills of the artisan. With reference to Figures 3, 4, 6 and 7, while nest openings have been described as being completely open, i.e., nest openings allow substantially all balls in ball grid array be exposed, nest openings may instead be only partially open. A partially open nest opening may be such that only some of the balls in a ball grid array are effectively directly exposed to a vacuum, while others are shielded from direct exposure to the vacuum. The use of partially open nest openings may be effective in allowing a substrate to be securely held by a vacuum during dicing. However, wash and dry processes used to remove residue from diced integrated circuit chips may become more complicated in that removal of residue from around the ball may be difficult when not all of the balls are exposed.

The nest openings in a nest have general been described as being uniform. That is, all the nest openings in a single nest have been described as being of substantially the same shape. However, in one embodiment, the nest openings in a single nest may not all be of substantially the same shape. For example, some nest openings may be polygonal in shape, while other nest openings may be circular in shape. With reference to Figures 3, 4, 6 and 7, a nest with a nest openings which are of a variety of different shapes may be particularly suitable for use with a substrate which includes integrated circuit chips that have a variety of different ball grid array footprints.

It should be appreciated that although nest openings have been described as having polygonal, e.g., rectangular, and circular shape, nest openings may generally have any shape that is suitable for accommodating ball grid arrays. By way of example, in the event that a ball grid array has an irregular shape, the corresponding nest opening may also have substantially the same irregular shape. Such irregular shapes may include, but are not limited to, irregular polygonal shapes and assorted curved shape.

As described above, nest are arranged to hold substrates which are substantially rectangular in shape. It should be appreciated, however, that nests may generally be reconfigured to accommodate substrates of virtually any size and shape. Nest may take on an overall circular shape when the substrates which are to held using nests are circular in shape. Alternatively, nest may take on a general polygonal shape when the substrates which are to be held are effectively polygonal in shape.

While nests may include channel, or steps, which are intended to prevent scrap material generated during dicing processes from freely "flying" around, nests may not necessarily include channels. In one embodiment, nests may include clamping mechanism which hold scrap in place. Alternatively, in another embodiment, scrap material may not be constrained from moving after the dicing process if it is determined that substantially loose scrap material is not detrimental to the overall fabrication process.

Further, substrates which are retained in a nest may include any number of integrated circuit chips. The number of chips depends both on the size of the chips and the size of the overall substrate. In one embodiment, a substrate which is approximately 203 mm by 63 mm (8 inches by 2.5 inches) may include 189 chips, each with a seven by seven ball grid array, in a twenty-seven by seven overall array. It should be appreciated, however, that the size of substrates and chips on the substrate may vary widely.

Nest have been described as being formed from aluminum or, more generally, metal. Typically, however, nest may be formed from any suitable material. For example, a nest may be formed from plastic. A plastic nest is likely to be lighter than a metal nest of the same size and shape and, as a result, may be preferable when the weight of the nest is an issue.

The steps associated with dicing a substrate that is held by a nest may generally be widely varied. Steps may be altered, added, or removed By way of example, a substrate may be loaded into a nest, which is then placed into a magazine of loaded nests that are placed one at a time onto a vacuum chuck. In other words, loaded nests may be queued prior to loading each nest onto a vacuum chuck. Also, in one embodiment, a covered nest fixture may be uncovered prior to removing the covered nest fixture from a wash and dry unit.

While the use of a nest has been described with respect to substantially automatic dicing process, it should be appreciated that the nest may also be used in semi-automatic dicing processes. For instance, the nest may be used in a dicing process which requires manual loading the nest onto a vacuum chuck. The nest may also be used in a dicing process which requires that the nest is manual moved from a vacuum chuck to a wash and dry unit.

As described in relation to Figures 3, 4, 6 and 7 above, a substrate is placed in a nest such that the BGA side of the substrate faces into the nest. In other words, the "non-smooth" side of the substrate is effectively placed into the nest, and comes into substantially direct contact with a vacuum during a dicing process. In the embodiments of the invention however, a substrate is placed into a nest such that the "smooth," e.g., non-BGA or die, side faces into the nest. In such cases, the substrate may be cut from the non-smooth side. The present examples are to be considered as illustrative and not restrictive, and the invention is not to be limited to the details given herein, but may be modified within the scope of the appended claims.

## Claims

1. An arrangement configured to support a substrate (102) during a dicing process, said substrate having a first substrate side and a second substrate side, said first substrate side being smoother than second substrate side, the arrangement comprising:
a nest (502) having a first nest side and a second nest side, said nest (502) including a grid which defines at least one nest opening (504), said nest opening (504) having an opening area that is smaller than an area of a die (140)diced from said substrate (102); and
a vacuum retainer plate (520) having thereon at least one vacuum pedestal (522), said vacuum pedestal (522) being configured to be disposed through said nest opening when said nest (502) is mated with said vacuum retainer plate (520), **characterised in that**
said vacuum pedestal (522) has an upper surface formed of a resilient material and protrudes above said first nest side of said nest (502) when said vacuum pedestal (522) is disposed through said nest opening from said nest side to lift said substrate (102) off said first nest side when said substrate (102) is positioned on said nest (502) with said first substrate side facing said first nest side and when said nest (502) is mated with said vacuum retainer plate (520).

2. The arrangement recited in claim 1, wherein said substrate (102) is diced when said substrate (102) is lifted off said first nest side of said nest (502) while said nest (502) is mated with said vacuum retainer plate (520).

3. The arrangement recited in claim 1, wherein said vacuum pedestal (522) includes a vacuum port (528) configured to hold said die (140) securely against an upper surface of said vacuum pedestal (522) when said nest (502) is mated with said vacuum retainer plate (520) and vacuum is turned on.

4. The arrangement recited in claim 3, wherein said vacuum pedestal (522) further includes a countersunk portion (902) disposed in said upper surface, said countersunk portion (902) being in vacuum communication with said vacuum port (904), a diameter of said countersunk portion (902) being larger than a diameter of said vacuum port.

5. The arrangement recited in claim 1, wherein said nest opening (504) further having at least one retainer wall (506) disposed on said first nest side proximate said opening area

6. The arrangement recited in claim 5,wherein a height of said retaining wall (506) is less than a height with which said vacuum pedestal (522) protrudes above said first nest side of said nest (502).

7. The arrangement recited in claim 1, wherein said vacuum retainer plate (520) further comprises a channel (550) disposed between adjacent vacuum pedestals (522) of said vacuum retainer plate (520), said channel (550) being arranged to receive a saw blade during said dicing process.

8. The arrangement recited in claim 7, wherein a width of said channel (550) is substantially wider than a width of said saw blade to minimize blade fouling during said dicing process.

9. The arrangement recited in claim 1, wherein said at least one nest opening (504) defined by said grid is substantially rectangularly shaped.

10. The arrangement recited in claim 1, further comprises at least one holding mechanism, said holding mechanism being arranged to substantially secure said nest (502) to a dicing apparatus.

11. The arrangement recited in claim 1, wherein said nest (502) further comprises a locator pin (510) for aligning said substrate (102) with said nest (502) when said substrate (102) is disposed on said first nest side of said nest (502).

12. The arrangement recited in claim 1 further comprises a top cover configured to be disposed above said substrate (102), said top cover including at least one contact post that contacts said die (140) to force said die (140) against said first nest side when said vacuum retainer plate (520) is disengaged from said nest (502).

13. The arrangement recited in claim 1, wherein said first substrate side represents a mold side of said substrate (102), said second substrate side represents a ball grid array side of said substrate (102).

14. The arrangement recited in claim 1, wherein said vacuum retainer plate (520) includes a vacuum block platform (520A) and a base plate (520B), said vacuum block platform (520A) having thereon said vacuum pedestal (522), said base plate (520B) is configured to distribute vacuum among a plurality of vacuum ports of a plurality of vacuum pedestals (522) of said vacuum retainer plate (520).

15. The arrangement recited in claim 14, wherein said vacuum block platform (520A) includes a vacuum block portion (704) and a vacuum block base (702), said vacuum block portion (704) including said vacuum pedestal (522) and being configured to be coupled in a sealing relationship with said vacuum block base(520A).

16. The arrangement recited in claim 15, wherein said vacuum block portion (704) is formed from said resilient material, and said vacuum block base (702) is formed from a material different from said resilient material.

17. The arrangement recited in claim 16, wherein said vacuum block portion (704) is coupled to said vacuum block base (702) by a damp (802).

18. The arrangement recited in claim 1, wherein only a upper portion of said vacuum pedestal (522) is formed from said resilient material.

19. The arrangement recited in claim 1, wherein said vacuum pedestal (522) includes a resilient capping arrangement configured to disposed atop said vacuum pedestal (522).

20. The arrangement recited in claim 1, wherein said resilient material is substantially non-reactive with de-ionized water.

21. The arrangement recited in claim 1, wherein said resilient material is substantially anti-static.

22. The arrangement recited in claim 1, wherein said resilient material is made of a synthetic material.

23. The arrangement recited in claim 1, wherein said vacuum retainer plate (520) further comprises a channel (550) disposed between adjacent vacuum pedestals (522) of said vacuum retainer plate (520), said channel (550) being arranged to receive scrap material created from said substrate by said dicing process.

## Revendications

1. Agencement configuré pour supporter un substrat (102) pendant un processus de découpage en tranche, ledit substrat ayant un premier côté de substrat et un second côté de substrat, ledit premier côté de substrat étant plus lisse que le second côté de substrat, l'agencement comportant :
une empreinte (502) ayant un premier côté d'empreinte et un second côté d'empreinte, ladite empreinte (502) comportant une grille qui définit au moins une ouverture d'empreinte (504), ladite ouverture d'empreinte (504) ayant une aire d'ouverture qui est inférieure à une aire d'une matrice (140) découpée en tranche à partir dudit substrat (102) ; et
une plaque de retenue de vide (520) ayant sur celle-ci au moins un socle de vide (522), ledit socle de vide (522) étant configuré pour être disposé à travers ladite ouverture d'empreinte lorsque ladite empreinte (502) est appariée avec ladite plaque de retenue de vide (520), **caractérisé en ce que**
ledit socle de vide (522) a une surface supérieure formée en un matériau élastique, et fait saillie au-dessus dudit premier côté d'empreinte de ladite empreinte (502) lorsque ledit socle de vide (522) est disposé à travers ladite ouverture d'empreinte à partir dudit côté d'empreinte pour lever ledit substrat (102) hors dudit premier côté d'empreinte lorsque ledit substrat (102) est positionné sur ladite empreinte (502) avec ledit premier côté de substrat en vis-à-vis dudit premier côté d'empreinte, et lorsque ladite empreinte (502) est appariée avec ladite plaque de retenue de vide (520).

2. Agencement selon la revendication 1, dans lequel ledit substrat (102) est découpé en tranche lorsque ledit substrat (102) est levé hors dudit premier côté d'empreinte de ladite empreinte (502) tandis que ladite empreinte (502) est appariée avec ladite plaque de retenue de vide (520).

3. Agencement selon la revendication 1, dans lequel ledit socle de vide (522) comporte un orifice de vide (528) configuré pour maintenir ladite matrice (140) de manière sûre contre une surface supérieure dudit socle de vide (522) lorsque ladite empreinte (502) est appariée avec ladite plaque de retenue de vide (520), et un vide est ouvert.

4. Agencement selon la revendication 3, dans lequel ledit socle de vide (522) comporte en outre une partie fraisée (902) disposée dans ladite surface supérieure, ladite partie fraisée (902) étant en communication de vide avec ledit orifice de vide (904), un diamètre de ladite partie fraisée (902) étant plus grand qu'un diamètre dudit orifice de vide.

5. Agencement selon la revendication 1, dans lequel ladite ouverture d'empreinte (504) a en outre au moins une paroi de retenue (506) disposée sur le premier côté d'empreinte à proximité de ladite aire d'ouverture.

6. Agencement selon la revendication 5, dans lequel une hauteur de ladite paroi de retenue (506) est inférieure à une hauteur à laquelle ledit socle de vide (522) fait saillie au-dessus du premier côté d'empreinte de ladite empreinte (502).

7. Agencement selon la revendication 1, dans lequel ladite plaque de retenue de vide (520) comporte en outre un canal (550) disposé entre des socles de vide adjacents (522) de ladite plaque de retenue de vide (520), ledit canal (550) étant agencé pour recevoir une lame de scie pendant ledit processus de découpage en tranche.

8. Agencement selon la revendication 7, dans lequel une largeur dudit canal (550) est sensiblement plus large qu'une largeur de ladite lame de scie pour minimiser l'encrassement de lame pendant ledit processus de découpage en tranche.

9. Agencement selon la revendication 1, dans lequel ladite au moins une ouverture d'empreinte (504) définie par ladite grille est de forme sensiblement rectangulaire.

10. Agencement selon la revendication 1, comportant en outre au moins un mécanisme de maintien, ledit mécanisme de maintien étant agencé pour fixer ladite empreinte (502) de manière sensiblement sûre sur un dispositif de découpage en tranche.

11. Agencement selon la revendication 1, dans lequel ladite empreinte (502) comporte en outre une broche de positionnement (510) pour aligner ledit substrat (102) avec ladite empreinte (502) lorsque ledit substrat (102) est disposé sur ledit premier côté d'empreinte de ladite empreinte (502).

12. Agencement selon la revendication 1, comportant en outre un couvercle supérieur configuré pour être disposé au-dessus dudit substrat (102), ledit couvercle supérieur incluant au moins un montant de contact qui vient en contact avec ladite matrice (140) pour pousser ladite matrice (140) contre ledit premier côté d'empreinte lorsque ladite plaque de retenue de vide (520) est libérée de ladite empreinte (502).

13. Agencement selon la revendication 1, dans lequel ledit premier côté de substrat représente un côté de moule dudit substrat (102), et ledit second côté de substrat représente un côté de boîtier à billes dudit substrat (102).

14. Agencement selon la revendication 1, dans lequel ladite plaque de retenue de vide (520) comporte une plate-forme de bloc de vide (520A) et une plaque de base (520B), ladite plate-forme de bloc de vide (520A) ayant sur celle-ci ledit socle de vide (522), ladite plaque de base (520B) étant configurée pour répartir le vide parmi une pluralité d'orifices de vide d'une pluralité de socles de vide (522) de ladite plaque de retenue de vide (520).

15. Agencement selon la revendication 14, dans lequel ladite plate-forme de bloc de vide (520A) comporte une partie de bloc de vide (704) et une base de bloc de vide (702), ladite partie de bloc de vide (704) incluant ledit socle de vide (522) et étant configurée pour être couplée de manière étanche à ladite base de bloc de vide (520A).

16. Agencement selon la revendication 15, dans lequel ladite partie de bloc de vide (704) est formée à partir dudit matériau élastique, et ladite base de bloc de vide (702) est formée à partir d'un matériau différent dudit matériau élastique.

17. Agencement selon la revendication 16, dans lequel ladite partie de bloc de vide (704) est coupée à ladite base de bloc de vide (702) par une pince (802).

18. Agencement selon la revendication 1, dans lequel seule une partie supérieure dudit socle de vide (522) est formée à partir dudit matériau élastique.

19. Agencement selon la revendication 1, dans lequel ledit socle de vide (522) comporte un agencement de recouvrement élastique configuré pour être disposé au-dessus dudit socle de vide (522).

20. Agencement selon la revendication 1, dans lequel ledit matériau élastique est sensiblement non-réactif avec de l'eau déionisée.

21. Agencement selon la revendication 1, dans lequel ledit matériau élastique est sensiblement antistatique. ,

22. Agencement selon la revendication 1, dans lequel ledit matériau élastique est réalisé en un matériau synthétique.

23. Agencement selon la revendication 1, dans lequel ladite plaque de retenue de vide (520) comporte en outre un canal (550) disposé entre des socles de vide adjacents (522) de ladite plaque de retenue de vide (520), ledit canal (550) étant agencé pour recevoir des matériaux de déchets créés à partir dudit substrat par ledit processus de découpage en tranche.

## Patentansprüche

1. Eine Anordnung zum Tragen eines Substrates (102) während eines Trennverfahrens, wobei das Substrat eine erste Substratseite und eine zweite Substratseite hat, und die erste Substratseite glatter ist als die zweite Substratseite, und wobei die Anordnung umfasst:
eine Aufnahmeplatte (502) mit einer ersten Plattenseite und einer zweiten Plattenseite, wobei die Aufnahmeplatte (502) ein Gittermuster umfasst, das mindestens eine Aufnahme-Öffnung (504) definiert, und diese Öffnung (504) eine Öffnungsfläche hat, die kleiner ist als die Fläche eines Würfels (140), der aus diesem Substrat (102) herausgeschnitten wird; und
eine Vakuum-Halteplatte (520), auf der mindestens ein Vakuumsockel (522) sitzt, wobei der Vakuumsockel (522) so geformt ist, dass er in die Aufnahmeöffnung hineingesteckt werden kann, wenn die Aufnahmeplatte (502) mit der Vakuum-Halteplatte (520) zusammengesteckt wird, **dadurch gekennzeichnet, dass**
der Vakuumsockel (522) eine obere Fläche hat, die aus einem elastischen Material gebildet ist und über die erste Seite der Aufnahmeplatte (502) hervorsteht, wenn der Vakuumsockel (522) durch die Aufnahmeöffnung von dieser Seite der Aufnahmeplatte her gesteckt wird, um das Substrat (102) von der ersten Seite der Aufnahmeplatte abzuheben, wenn das Substrat (102) auf der Aufnahmeplatte (502) so positioniert ist, dass die erste Substratseite der ersten Seite der Aufnahmeplatte gegenüberliegt, und wenn die Aufnahmeplatte (502) mit der Vakuum-Halteplatte (520) zusammengesteckt wird.

2. Anordnung nach Anspruch 1, bei der das Substrat (102) in Würfel geschnitten wird, wenn das Substrat (102) von der ersten Seite der Aufnahmeplatte (502) abgehoben wird, während die Aufnahmeplatte (502) mit der Vakuum-Halteplatte (520) zusammengesteckt ist.

3. Anordnung nach Anspruch 1, bei der der Vakuumsockel (522) einen Vakuumdurchlass (528) umfasst, der so geformt ist, dass der Würfel (140) sicher gegen die obere Fläche des Vakuumsockels (522) gehalten wird, wenn die Aufnahmeplatte (502) mit der Vakuum-Halteplatte (520) zusammengesteckt ist und das Vakuum eingeschaltet ist.

4. Anordnung nach Anspruch 3, bei der der Vakuumsockel (522) außerdem einen versenkten Bereich (902) umfasst, der in der oberen Fläche angeordnet ist, wobei der versenkte Bereich (902) in Vakuumverbindung mit dem Vakuumdurchlass (904) steht, und wobei der Durchmesser des versenkten Bereichs (902) größer ist als der Durchmesser des Vakuumdurchlasses.

5. Anordnung nach Anspruch 1, bei der die Öffnung (504) der Aufnahmeplatte außerdem mindestens eine Haltewand (506) umfasst, die auf der ersten Seite der Aufnahmeplatte in unmittelbarer Nähe der Öffnungsfläche angeordnet ist.

6. Anordnung nach Anspruch 5, bei der die Höhe der Haltewand (506) kleiner ist als die Höhe, mit der der Vakuumsockel (522) über die erste Seite der Aufnahmeplatte (502) hervorsteht.

7. Anordnung nach Anspruch 1, bei der die Vakuum-Halteplatte (520) außerdem einen Kanal (550) umfasst, der zwischen benachbarten Vakuumsockeln (522) der Vakuum-Halteplatte (520) liegt, wobei der Kanal (550) so angeordnet ist, dass er während des Trennverfahrens ein Sägeblatt aufnimmt.

8. Anordnung nach Anspruch 7, bei der die Breite des Kanals (550) wesentlich größer ist als die Breite des Sägeblatts, um das Verschmutzen des Sägeblatts während des Trennverfahrens so gering wie möglich zu halten.

9. Anordnung nach Anspruch 1, bei der mindestens eine der von dem Gittermuster definierten Aufnahmeöffnungen (504) der Aufnahmeplatte eine im wesentlichen rechtwinklige Form hat.

10. Anordnung nach Anspruch 1, die außerdem mindestens einen Haltemechanismus umfasst, wobei dieser Haltemechanismus so angeordnet ist, dass er die Aufnahmeplatte (502) an einer Trennvorrichtung sicher befestigt.

11. Anordnung nach Anspruch 1, bei der die Aufnahmeplatte (502) außerdem einen Paßstift (510) umfasst, um das Substrat (102) mit der Aufnahmeplatte (502) in Linie auszurichten, wenn das Substrat (102) auf der ersten Seite der Aufnahmeplatte (502) aufgelegt wird.

12. Anordnung nach Anspruch 1, die ferner eine obere Abdeckung umfasst, die so geformt ist, dass sie über das Substrat (102) gelegt werden kann, wobei die obere Abdeckung mindestens einen Kontaktstift hat, der den Würfel (140) berührt, um den Würfel (140) gegen die erste Seite der Aufnahmeplatte zu drücken, wenn die Vakuum-Halteplatte (520) von der Aufnahmeplatte (502) abgehoben wird.

13. Anordnung nach Anspruch 1, bei der die erste Substratseite die Formseite des Substrates (102) darstellt und die zweite Substratseite die Kontaktpunktgitter-Anordnung des Substrates (102) darstellt.

14. Anordnung nach Anspruch 1, bei der die Vakuum-Halteplatte (520) eine Vakuumblock-Platte (520A) und eine Grundplatte (520B) umfasst, wobei sich auf der Vakuumblock-Platte (520A) der Vakuumsockel (522) befindet, und die Grundplatte (520B) so konzipiert ist, dass sie Vakuum durch eine Vielzahl von Vakuumdurchlässen einer Vielzahl von Vakuumsockeln (522) der Vakuum-Halteplatte (520) verteilt.

15. Anordnung nach Anspruch 14, bei der die Vakuumblock-Platte (520A) ein Vakuumblock-Teil (704) und einen Vakuumblock-Boden (702) umfasst, wobei das Vakuumblock-Teil (704) den Vakuumsockel (522) einschließt und so konzipiert ist, dass es in abdichtender Weise mit dem Vakuumblock-Boden (702) verbunden ist.

16. Anordnung nach Anspruch 15, bei der das Vakuumblock-Teil (704) aus dem bereits genannten elastischen Material gebildet ist, und der Vakuumblock-Boden (702) aus einem Material gebildet ist, das sich von dem elastischen Material unterscheidet.

17. Anordnung nach Anspruch 16, bei der das Vakuumblock-Teil (704) mit dem Vakuumblock-Boden (702) durch eine Klemmvorrichtung (802) verbunden ist.

18. Anordnung nach Anspruch 1, bei der nur der obere Teil des Vakuumsockels (522) aus dem elastischen Material gebildet ist.

19. Anordnung nach Anspruch 1, bei der der Vakuumsockel (522) eine elastische Abdeckeinrichtung umfasst, die so geformt ist, dass sie auf den Vakuumsockel (522) aufgesetzt werden kann.

20. Anordnung nach Anspruch 1, bei der das elastische Material im wesentlichen nicht mit entionisiertem Wasser reagiert.

21. Anordnung nach Anspruch 1, bei der das elastische Material im wesentlichen antistatisch ist.

22. Anordnung nach Anspruch 1, bei der das elastische Material aus einem synthetischen Material hergestellt ist.

23. Anordnung nach Anspruch 1, bei der die Vakuum-Halteplatte (520) außerdem einen Kanal (550) umfasst, der zwischen benachbarten Vakuumsockeln (522) der Vakuum-Halteplatte (520) liegt, wobei der Kanal (550) so angeordnet ist, dass er Abfallmaterial aufnimmt, das vom Substrat beim Trennverfahren anfällt.
